Europäisches Patentamt

European Patent Office

Office européen des brevets

(11) Publication number: **0 157 482 B1**

# EUROPEAN PATENT SPECIFICATION

(45) Date of publication of patent specification: **15.05.91**  (51) Int. Cl.5: **H03H 9/42**, H03H 9/76

(21) Application number: **85301073.4**

(22) Date of filing: **19.02.85**

(54) Surface acoustic wave device.

(30) Priority: **29.03.84 GB 8408168**

(43) Date of publication of application:
**09.10.85 Bulletin 85/41**

(45) Publication of the grant of the patent:
**15.05.91 Bulletin 91/20**

(84) Designated Contracting States:
**DE FR GB**

(56) References cited:
**US-A- 3 715 674**
**US-A- 3 873 946**

**PATENTS ABSTRACTS OF JAPAN, vol. 3, no.
52 (E-108), 7th May 1979, page 104 E108; &
JP-A-54 31 252**

**THE TRANSACTIONS OF THE IECE OF JA-
PAN, vol. E62, no. 11, November 1979, pages
775-778, Tokyo, JP; J. TEMMYO et al.: "A new
tapping design for low-distortion SAW
tapped delay lines"**

(73) Proprietor: **EMI Limited**
**Blyth Road**
**Hayes Middlesex, UB3 1BP(GB)**

(72) Inventor: **Blundell, Stephen James**
**25, Avenue Rise**
**Bushey Hertfordshire(GB)**

(74) Representative: **Marsh, Robin Geoffrey**
**Thorn EMI Patents Limited The Quadrangle**
**Westmount Centre Uxbridge Road**
**Hayes Middlesex, UB4 0HB(GB)**

## Description

This invention relates to a surface acoustic wave device and it relates especially to such a device suitable for subjecting a surface acoustic wave (SAW) to a number of different delays.

A surface acoustic wave device typically comprises a substrate of a piezoelectric material, e.g. quartz lead zirconate ceramic (PZT) or lithium niobate ($LiNbO_3$), which is provided, at one of its major surfaces, with an input transducer for launching a SAW along a suitable cystallographic direction and an output transducer for receiving the wave, after a delay due to the propagation time. Usually, the input and output transducers are in the form of interdigital arrays of strip electrodes applied to the substrate by a suitable photolithographic technique.

The value of a device of this and lies in the fact that the velocity of a SAW propagating at the surface of a piezoelectric substrate is much smaller than that of an electromagnetic wave used to excite the input transducer; thus relatively large delays can be achieved.

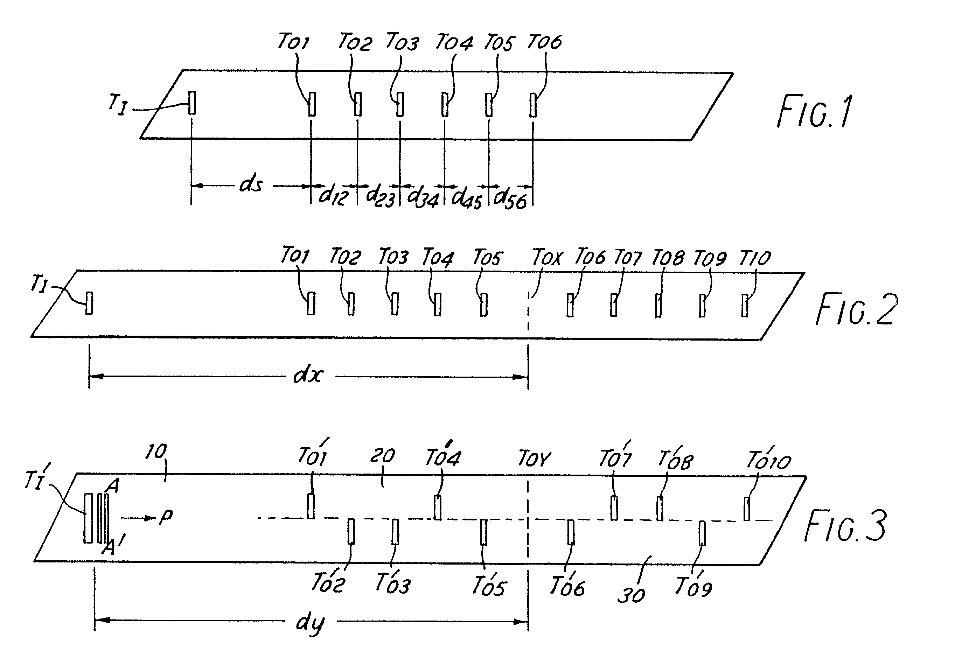

It may be desirable in practice to subject a SAW to different delays and to this end a plurality of output transducers is arranged on the substrate, individual transducers being spaced apart along the propogation direction. A device of this kind is shown, by way of example, in Figure 1; the input transducer is represented at $T_I$ and six output transducers are represented at $T_{01}$, $T_{02}$ ... $T_{06}$.

A wave launched by the input transducer is received at the output transducers $T_{01}$, $T_{02}$ .... $T_{06}$ after respective delays $t_s$; $t_s + t_{12}$; .... $t_s + t_{12} + t_{23} + t_{34} + t_{45} + t_{56}$ where $t_s$ is the elapsed time due to propagation of the wave over a distance $d_s$ separating the input transducer and the nearest ouput transducer $T_{01}$, and $t_{12}$; $t_{23}$ .... $t_{56}$ are the elapsed times due to propagation of the wave over distances $d_{12}$, $d_{23}$ .... $d_{56}$ separating respective pairs of adjacent output transducers.

A wave may suffer a partial reflection at an output transducer and, in these circumstances, transducer $T_{01}$, for example, may receive a wave after a delay $t_s + 2t_{12}$ due to a reflection occurring at transducer $T_{02}$. If, as is commonly the case, the output transducers are spaced apart at regular intervals on the substrate such that $t_{12} = t_{23} = ....$ $t_{56}$ a wave may be received simultaneously at different output transducers. Far example, a wave received at transducers $T_{01}$ and $T_{03}$ may be subject to the same delay $t' = t_s + 2t_{12} = t_s + t_{12} + t_{23}$.

In some signal processing applications it is desirable to arrange that a surface acoustic wave device be capable of rejecting a wave which has been subjected to a specific (undesirable) delay. Hitherto, it has been customary to omit one of the output transducers. As shown in Figure 2 of the accompanying drawings, an output transducer which would otherwise occupy a position referenced at $T_{OX}$, intermediate transducers $T_{05}$ and $T_{06}$, has been omitted - thus a wave delayed by an amount $t_x$, the elapsed time due to propagation of the wave directly over a distance $d_x$ on the substrate, as shown, remains undetected.

In practice, however, a signal delayed by $t_x$ may still be received, albeit of reduced amplitude, on account of reflections occurring at the output transducers and, in general, this will happen whenever the total path length due to reflections corresponds to the elapsed time $t_x$. Thus, for example, a wave received at the output transducer $T_{04}$ may be subject to a delay $t_x$ on account of a reflection occurring at output transducer $T_{05}$.

It is an object of the present invention to provide a surface accoustic wave device wherein the above-mentioned problem is substantially alleviated.

Accordingly there is provided a surface acoustic wave device wherein a substrate (10) of a piezoelectric material is provided with input transducer means ($T'_I$) for launching a surface acoustic wave in a fixed, propagation direction (P) and a plurality of output transducers, ($T'_{01}$...$T'_{010}$) spaced apart along said fixed, propagation direction (P) to receive surface acoustic waves subject to respective delays so launched, characterised in that some of said output transducers are arranged on a first track (20) on the substrate and others of said output tranducers are arranged on a different track (30) on the substrate, whereby the distribution of output tranducers on the first and second tracks is such that surface acoustic waves, of delay values which would have been received only by virtue of reflections at output transducers if the output transducers had been arranged at the same spacing but along a single track only, are avoided.

In a preferred embodiment the first and different tracks are on the same side of said input transducer means.

In order that the invention may be carried into effect an embodiment thereof is now described, by way of example only, by reference to Figure 3 of the accompanying drawings which shows a perspective view of a surface acoustic wave device.

Referring now to Figure 3, a substrate 10 is provided, at a major surface, with an input transducer arrangement $T'_I$ arranged to launch a relative broad wave along a fixed, propagation direction P. The wavefront thus presented is shown at AA'.

In this example the output transducers $T'_{01}$, $T'_{02}$ ... $T_{0'10}$ are arranged at regular intervals along the propagation direction, except for an interruption at the position referenced $T_Y$ where a transducer has been omitted. With this arrangement, a wave delayed by an amount $t_y$ the elapsed time due to propagation of a wave directly from the input transducer to position $T_Y$ remains undetected.

Moreover, the output transducers are arranged on the substrate on two distinct tracks, in side-by-side relationship.

Transducers $T'_{01}$, $T'_{04}$, $T'_{07}$, $T'_{08}$ and $T'_{010}$ are arranged on a first track, indicated generally at 20, and

transducers $T'_{02}$, $T'_{03}$, $T'_{05}$, $T'_{06}$ and $T'_{09}$ are arranged on a second track, parallel to the first, indicated generally at 30.

As will be apparent from the drawing, the relative spacings of the transducers in each track is such that it is not possible to construct a path length, from the input transducer to any one of the output transducers, corresponding to the delay $t_y$ - even taking into account reflections occurring at the output transducer. Thus, in constrast to the device described hereinbefore by reference to Figure 2 wherein the transducers are arranged on a single track only, any significant wave, delayed by an amount $t_y$, remains undetected.

It will be appreciated that the output transducers need not necessarily be arranged along parallel tracks, in side-by-side relationship, as shown in Figure 3. In an alternative embodiment the input transducer may be positioned centrally on the substrate, the output transducers being arranged in their respective tracks 20, 30 on opposite sides of the input transducer, but with the same relative spacings.

## Claims

1. A surface acoustic wave device wherein a substrate (10) of a piezoelectric material is provided with input transducer means ($T'_I$) for launching a surface acoustic wave in a fixed, propagation direction (P) and a plurality of output transducers, ($T'_{01}$...$T'_{010}$) spaced apart along said fixed, propagation direction (P) to receive surface acoustic waves subject to respective delays so launched, characterised in that some of said output transducers are arranged on a first track (20) on the substrate and others of said output tranducers are arranged on a different track (30) on the substrate, whereby the distribution of output transducers on the first and second tracks is such that surface acoustic waves, of delay values which would have been received only by virtue of reflections at output transducers if the output transducers had been arranged at the same spacing but along a single track only, are avoided.

2. A surface acoustic wave device according to Claim 1 wherein said first and second tracks (20, 30) are arranged in side-by-side relationship on the same side of said input transducer means ($T'_I$)

3. A surface acoustic wave device according to Claim 1 wherein said first and second tracks (20, 30) are arranged on opposite sides of the said input transducer means ($T'_1$).

## Revendications

1. Un dispositif à ondes acoustiques de surface dans lequel un substrat (10) en matière piézoélectrique comporte des moyens transducteurs d'entrée ($T'_I$) pour lancer une onde acoustique de surface dans une direction de propagation fixe (P) et plusieurs transducteurs de sortie ($T'_{01}$...$T'_{010}$) espacés entre eux le long de ladite direction de propagation fixe (P) pour recevoir des ondes acoustiques de surface ainsi lancées soumises à des retards respectifs, caractérisé en ce que certains desdits transducteurs de sortie sont agencés sur une première piste (20) du substrat et d'autres parmi lesdits transducteurs de sortie sont agencés sur une piste différente (30) du substrat, grâce à quoi la répartition des transducteurs de sortie de la première et de la deuxième pistes est telle que sont évitées des ondes acoustiques de surface à valeurs de retard qui n'auraient été reçues qu'en raison de réflexions sur des transducteurs de sortie si les transducteurs de sortie avaient été agencés selon le même espacement mais le long d'une piste unique seulement.

2. Un dispositif à ondes acoustiques de surface selon la revendication 1 dans lequel ladite première et ladite deuxième pistes (20, 30) sont agencées dans une relation côte-à-côte sur le même côté desdits moyens transducteurs d'entrée ($T'_I$).

3. Un dispositif à ondes acoustiques de surface selon la revendication 1 dans lequel ladite première et ladite deuxième pistes (20, 30) sont agencées sur des côtés opposés desdits moyens transducteurs d'entrée ($T'_I$).

## Ansprüche

1. Akustische Oberflächenwellenvorrichtung, bei der ein Substrat (10) aus piezoelektrischem Material mit Eingangswandlermitteln ($T'_1$) zum

Starten einer akustischen Oberflächenwelle in einer festen Ausbreitungsrichtung (P) und mit einer Vielzahl von Ausgangswandlern (T'$_{01}$...T'$_{010}$), die im Abstand voneinander entlang der festen Ausbreitungsrichtung (P) angeordnet sind, um akustische Oberflächenwellen zu empfangen, die nach dem Start entsprechende Verzögerungen erfahren haben, versehen ist, dadurch gekennzeichnet, daß einige der Ausgangswandler auf einer ersten Spur (20) auf dem Substrat und andere Ausgangswandler auf einer unterschiedlichen Spur (30) auf dem Substrat angeordnet sind, wobei die Verteilung der Ausgangswandler auf der ersten und zweiten Spur so ist, daß akustische Oberflächenwellen mit Verzögerungswerten, die nur als Folge von Reflexionen an Ausgangswandlern empfangen worden wären, wenn die Ausgangswandler im selben Abstand, aber nur entlang einer einzelnen Spur angeordnet wären, vermieden werden.

2. Akustische Oberflächenwellenvorrichtung nach Anspruch 1, bei der die erste und zweite Spur (20, 30) Seite an Seite auf der selben Seite der Eingangswandlermittel (T'$_1$) angeordnet sind.

3. Akustische Oberflächenwellenvorrichtung nach Anspruch 1, bei der die erste und zweite Spur (20, 30) auf gegenüberliegenden Seiten der Eingangswandlermittel (T'$_1$) angeordnet sind.

FIG.1

$T_1$  $T_{01}$  $T_{02}$  $T_{03}$  $T_{04}$  $T_{05}$  $T_{06}$

$d_s$  $d_{12}$  $d_{23}$  $d_{34}$  $d_{45}$  $d_{56}$

FIG.2

$T_1$  $T_{01}$  $T_{02}$  $T_{03}$  $T_{04}$  $T_{05}$  $T_{0X}$  $T_{06}$  $T_{07}$  $T_{08}$  $T_{09}$  $T_{10}$

$dx$

FIG.3

$T'_1$  $T'_{01}$  $T'_{02}$  $T'_{03}$  $T'_{04}$  $T'_{05}$  $T_{0Y}$  $T'_{06}$  $T'_{07}$  $T'_{08}$  $T'_{09}$  $T'_{10}$

$A$  $A'$  $P$  10  20  30  $dy$